Europäisches Patentamt

European Patent Office

Office européen des brevets

(11) Veröffentlichungsnummer: **0 004 871**
**B1**

(12) **EUROPÄISCHE PATENTSCHRIFT**

(45) Veröffentlichungstag der Patentschrift:
07.10.81

(21) Anmeldenummer: 79100816.2

(22) Anmeldetag: 16.03.79

(51) Int. Cl.³: **H 01 L 27/08,** G 11 C 11/40,
H 01 L 27/02

(54) Monolithisch integrierte Halbleiteranordnung mit mindestens einer I2L-Struktur, Speicherzelle unter Verwendung einer derartigen Halbleiteranordnung sowie integrierte Speichermatrix unter Verwendung einer derartigen Speicherzelle.

(30) Priorität: 19.04.78 DE 2816949

(43) Veröffentlichungstag der Anmeldung:
31.10.79 Patentblatt 79/22

(45) Bekanntmachung des Hinweises auf die Patenterteilung:
07.10.81 Patentblatt 81/40

(84) Benannte Vertragsstaaten:
DE FR GB

(56) Entgegenhaltungen:

DE-A-2 612 666 (IBM)

Electronics, Band 51, Heft 12, Juni 1978,
New York, USA «Two popular bioplar
technologies combine in Philips' device»

IEEE Journal of Solid-State Circuits, Band
SC-12, Heft 2, April 1977, New York, USA
John M. Herman et al. «Second Generation
I²L/MTL: A 20 ns Process/Structure»

(73) Patentinhaber: International Business Machines
Corporation, Armonk, N.Y. 10504 (US)

(72) Erfinder: Heuber, Klaus, Dipl.-Ing., Taunusstrasse 62,
D-7030 Böblingen (DE)
Erfinder: Klink, Erich, Dipl.-Ing., Max-Eyth-Strasse 34,
D-7036 Schönaich (DE)
Erfinder: Rudolph, Volker, Dipl.-Phys., Finkenweg 20,
D-7031 Aidlingen 3 (DE)
Erfinder: Wiedmann, Siegfried, Dr. Ing., Im Himmel 64A,
D-7000 Stuttgart 80 (DE)

(74) Vertreter: Gaugel, Heinz, Dipl.-Ing., Schönaicher
Strasse 220, D-7030 Böblingen (DE)

Monolithisch integrierte Halbleiteranordnung mit mindestens einer I²L-Struktur, Speicherzelle unter Verwendung einer derartigen Halbleiteranordnung sowie integrierte Speichermatrix unter Verwendung einer derartigen Speicherzelle

Die Erfindung betrifft eine monolithisch integrierte Halbleiteranordnung mit mindestens einer I²L-Struktur, die eine Injektionszone und einen invertierenden Transistor enthält, wobei die Injektionszone und lateral dazu die Basiszone des gleichen ersten Leitungstyps in einer die Emitterzone des Transistors bildenden Halbleiterschicht des zweiten Leitungstyps angeordnet sind, der Transistor durch eine in der Basiszone liegende Kollektorzone des zweiten Leitungstyps vervollständigt ist und die I²L-Struktur mindestens teilweise von einer in einem vorgegebenen Abstand von der Injektions- und Basiszone in die die Emitterzone des Transistors bildende Halbleiterschicht eingebrachten Trennzone umgeben ist.

Weiterhin betrifft die Erfindung eine Speicheranordnung, deren Speicherzellen jeweils aus zwei derartigen, nach Art eines Flip-Flops kreuzgekoppelten I²L-Strukturen bestehen, sowie eine Speichermatrix unter Verwendung einer derartigen Speicherzelle.

Auf dem Gebiet der logischen Verknüpfungsschaltungen mit Bipolartransistoren hat in den letzten Jahren eine bemerkenswerte Weiterentwicklung stattgefunden, die in der Fachwelt grosse Aufmerksamkeit auf sich gezogen hat und unter der Bezeichnung MTL (Merged Transistor Logic) oder auch I²L (Integrated Injection Logic) breiten Eingang in die Fachliteratur gefunden hat. Es wird beispielsweise auf die Aufsätze im IEEE Journal of Solid-State Circuits, Vol. SC-7 Nr. 5, Oktober 1972, Seiten 340 ff und 346 ff verwiesen. Als zugehörige Patentliteratur seien beispielsweise die US-Patentschriften und 3 816 758 genannt. Dieses Injektions-Logikkonzept beruht im wesentlichen auf invertierenden Ein- oder Mehrfachkollektortransistoren, die durch direkte, d.h., im Innern des Halbleiterkörpers vor sich gehende Injektion von Minoritätsladungsträgern in die Nähe (Grössenordnung einer Diffusionslänge) ihrer Emitter-Basis-Übergänge gespeist werden.

Dieses bipolare Logikkonzept ist durch kurze Schaltzeiten ausgezeichnet. Ausserdem ist die Eignung zum Aufbau extrem hochintegrierter logischer Grossschaltungen mit einer hohen Zahl von auf einem einzelnen Halbleiterplättchen herstellbaren Verknüpfungsgliedern hervorzuheben. Um logische Schaltungen in hochintegrierter Technik herstellen zu können, müssen sie unter anderem im wesentlichen drei Voraussetzungen erfüllen. Die Grundschaltungen müssen möglichst einfach und platzsparend sein, um möglichst viele davon auf einem Halbleiterplättchen unterbringen zu können. Die Schaltungen müssen ausserdem so ausgelegt sein, dass eine ausreichende Geschwindigkeit keinen übermässigen Anstieg der Verlustleistung auf dem Halbleiterplättchen zur Folge hat, was gleichbedeutend mit der Forderung nach einem möglichst kleinen Produkt aus den Faktoren Verzögerungszeit und Verlustleistung pro Verknüpfungsfunktion ist. Schliesslich muss zur Erzielung einer guten Ausbeute und damit aus wirtschaftlichen aber auch aus technologischen Gründen der erforderliche Herstellungsprozess einfach und gut beherrschbar sein. All diesen Gesichtspunkten trägt das genannte Logikkonzept grundsätzlich, insbesondere im Vergleich zu den existierenden anderen Logikkonzepten (z.B. TTL-Logik), Rechnung.

Eine Grundstruktur dieses Logikkonzeptes, wie es in den genannten US-Patentschriften dargelegt ist, besteht darin, dass in eine Halbleiterschicht eines ersten Leitungstyps in einem Abstand als Emitter- und Kollektorzonen einer lateralen Transistorstruktur dienende Zonen des zweiten Leitungstyps angeordnet sind. In der Kollektorzone der lateralen Transistorstruktur ist mindestens eine weitere Zone des dazu entgegengesetzten Leitungstyps als Kollektorzone einer invers betriebenen vertikalen, komplementären Transistorstruktur angeordnet. Die Kollektorzone der lateralen Transistorstruktur bildet gleichzeitig die Basiszone der vertikalen Transistorstruktur. Die Basiszone der lateralen und die Emitterzone der invers betriebenen vertikalen Transistorstruktur werden durch die Halbleiterschicht des ersten Leitungstyps gebildet. Zum Betrieb dieser Halbleiterstruktur als logische Grundschaltung wird ein Strom in die Emitterzone der lateralen Transistorstruktur eingeprägt, der in Abhängigkeit von dem an der Kollektorzone des lateralen bzw. der Basiszone des vertikalen Transistors angelegten Eingangssignal den das invertierte Ausgangssignal liefernden Strom durch die vertikale Transistorstruktur gesteuert. Durch die Zusammenlegung der gleichdotierten und auf gleichem Potential liegenden Zonen erhält man eine optimale integrierte Struktur, deren Herstellung im betrachteten Ausführungsbeispiel nur zwei Diffusionsprozesse erforderlich macht.

Andere bekannte Ausführungsformen dieser Grundschaltung bestehen aus einer Schichtstruktur mit vier Zonen unterschiedlichen Leitungstyps, die zwei vertikale, miteinander monolithisch vereinte Transistorstrukturen umfassen und in entsprechender Weise betrieben werden. Dabei erfolgt wiederum über die Emitterzone des einen Transistors die Injektion von Minoritätsladungsträgern, was die Stromversorgung der Grundschaltung bewirkt, während über die andere Transistorstruktur das Ausgangssignal geliefert wird.

Durch geeignete Kombination derartiger invertierender logischer Grundschaltungen lassen sich die angestrebten logischen Verknüpfungsschaltungen verwirklichen.

Zur Feststellung des Leit- bzw. Schaltzustandes einzelner invertierender Transistoren der Grundschaltungen als Ergebnis einer logischen Verknüpfung sind geeignete Abfühlschaltungen in den Signalweg einzuschalten. Diese Abfühlschaltungen belasten im allgemeinen die Signalwege und verursachen dadurch zusätzliche, unerwünschte Schaltzeiterhöhungen. Es stellt sich also die Frage, wie derartige Belastungen des Signalweges weitgehend reduziert werden können.

Die beschriebenen invertierenden, logischen Grundschaltungen sind nicht nur in hervorragender Weise zum Aufbau von logischen Verknüpfungsschaltungen geeignet, sie sind auch in vorteilhafter Weise als Baustein für monolithisch integrierte Speicherzellen einsetzbar. Derartige Speicherzellen finden insbesondere Anwendung in digitalen Datenverärbeitungsanlagen. Die Speicherzellen werden in einer Matrix angeordnet, so dass über entsprechende Selektionseinrichtungen jede einzelne Zelle adressiert und dabei Daten in sie eingeschrieben oder aus ihr ausgelesen werden können.

Es ist bekannt, dass bei invertierenden logischen Schaltungen jeweils zwei Stufen erforderlich sind, um Speicherzellen nach Art von bistabilen Kippstufen bzw. Flip-Flops zu erhalten. Eine Speicherzelle besteht also aus zwei derartigen Grundschaltungen, die symmetrisch ausgebildet sind und bei denen jeweils der Ausgang der einen mit dem Eingang der anderen Schaltung zur Erfüllung der Rückkoppelungsbedingung verbunden ist. Auf diese Weise entsteht die erforderliche Kreuzkoppelung, wie sie bei den üblichen Flip-Flops vorhanden ist.

Aus der DE-A-2 307 739 ist bereits eine Speicherzelle bekannt, die aus zwei der beschriebenen logischen Grundschaltungen zusammengesetzt ist und bei der der Kollektor des invertierenden Transistors der einen Grundschaltung jeweils mit der Basis des invertierenden Transistors der anderen Grundschaltung gekoppelt ist. Die beiden invertierenden Transistoren werden wiederum invers betrieben und bilden die eigentlichen Flip-Flop-Transistoren. Als Lastelement für beide Flip-Flop-Transistoren dient der über eine gesonderte Leitung angeschlossene komplementäre Transistor jeder Grundschaltung, über den die Injektion der Minoritätsladungsträger, also die Stromversorgung erfolgt. Zum Zwecke der Adressierung, also zum Einschreiben und Auslesen der Speicherzelle, ist zusätzlich die Basis jedes Flip-Flop-Transistors mit dem Emitter eines zugeordneten zusätzlichen, ebenfalls komplementären Adressier-Transistors verbunden, dessen Kollektor an der zugeordneten Bitleitung und dessen Basis an der Adressleitung liegt. Ausser dem das Lastelement bildenden, injizierenden Transistor ist also zusätzlich ein Adressier-Transistor erforderlich, der wiederum durch eine laterale Transistorstruktur gebildet wird.

Durch laterale Anordnung der beiden, jeweils eine Speicherzelle bildenden Schaltungen und Zusammenlegung der auf gleichem Potential liegenden Zonen erhält man die angestrebte einfache Halbleiterstruktur. Mit dieser bekannten Speicherzelle lässt sich eine Speichermatrix aufbauen, bei der die Speicherzellen in mindestens zwei horizontalen Zeilen und mindestens vier vertikalen Spalten angeordnet sind. Eine erste vertikale Adressleitung ist der ersten und zweiten und eine zweite vertikale Adressleitung ist der dritten und vierten Spalte zugeordnet. Weiterhin ist eine erste horizontale Adressleitung der ersten und eine zweite horizontale Adressleitung der zweiten Zeile zugeordnet. Schliesslich ist ein erstes Bitleitungspaar der ersten Spalte, ein zweites Begleitungspaar der zweiten und dritten Spalte und ein drittes Begleitungspaar der vierten Spalte zugordnet. Jedes Bitleitungspaar verläuft dabei vorzugsweise in vertikaler Richtung zwischen den zugeordneten Spalten.

Die Bitleitungen sind jeweils an die Kollektoren der Adressier-Transistoren, die erste Adressleitung an die Emitter der die Lastelemente bildenden Transistoren und die zweite Adressier-Leitung an die Basen der Adressier-Transistoren angeschlossen.

Ausgehend von der bekannten invertierenden logischen Grundschaltung ist aus der DE-A-2 612 666 bereits eine entsprechend verbesserte Grundschaltung bekannt, die insbesondere aufgrund ihrer gewählten Betriebsweise bei der Bildung von logischen Verknüpfungsschaltungen beträchtliche Vorteile bietet, wobei eine Belastung des eigentlichen Signalweges durch notwendige Abfühlschaltungen weitgehend vermieden wird. Dies wird dadurch erreicht, dass bei der als «Integrated Injection Logic» ($I^2L$) bekannten Grundschaltung der Leitzustand des invertierenden Transistors mit Hilfe einer in den Injektionsstromkreis, also den Betriebsstromkreis, eingefügten Abfühlschaltung abgefühlt wird. Diese Abfühlung erfolgt aufgrund des bei leitendem invertierendem Transistor in das Injektionsgebiet rückinjizierten Stromes. Bei der in der genannten Patentanmeldung ebenfalls vorgeschlagenen Anwendung dieses Prinzips in einer aus zwei derartigen, nach Art eines Flip-Flops zu einer Speicherzelle zusammengesetzten Schaltungen wird sowohl die Betriebsstromzuführung als auch die Kopplung der Schreib/Lese-Signale über an die Injektionszone angeschlossene Bitleitungen vorgenommen. Auf diese Weise werden keine gesonderten Adressier-Transistoren benötigt und die hierfür bei der bekannten Speicherzelle erforderliche zusätzliche Injektionszone kann entfallen.

Bei der Verwirklichung der aus der DE-A-2 612 666 bekannten $I^2L$-Grundschaltung und der damit aufgebauten Speicherzelle ergeben sich gewisse Probleme dann, wenn auf Minimalabmessungen der Struktur, also auf maximale Integrationsdichte Wert gelegt wird. Diese Minimalabmessungen, d.h., der minimal erreichbare Flächenbedarf je $I^2L$-Grundschaltung, sind im wesentlichen durch die technologisch bedingten Grenzen der kleinsten erreichbaren Abmessungen der Kontaktöffnungen und Diffusionsfenster in den bei der Herstellung angewandten photolithographischen Maskierungsprozessen zwangsläufig festgelegt.

Es ergeben sich also zwangsläufig Mindestabmessungen für die Injektionszone und die lateral dazu in die gemeinsame Halbleiterschicht eingebrachte Basiszone des invertierenden Transistors. Ausgehend von den also technologisch unumgänglichen Mindestabmessungen dieser Zonen ist es bei den meisten Anwendungen der Grundschaltung erforderlich, die Halbleiterstruktur durch eine in einem gewissen Abstand in die gemeinsame Halbleiterschicht eingebrachte Trennzone gegen benachbart integrierte Strukturen abzugrenzen. Diese Trennzone hat die Aufgabe, parasitäre laterale, von der Injektionszone und von der Basiszone des invertierenden Transistors ausgehende Injektionen von Minoritätsladungsträgern zu verhindern, die unerwünschte Ladungsspeichereffekte und parasitäre Transistorwirkungen in Verbindung mit angrenzenden Zonen hervorrufen und damit offensichtlich die Funktion der Struktur nachteilig beeinflussen könnten. Bei der topologischen Auslegung der Struktur ist auch darauf zu achten, dass für den Abstand der Trennzone von der Injektions- und der Basiszone ein gewisses Mindestmass einzuhalten ist, um parasitäre Kapazitäten klein zu halten, die zwischen Injektions- und Basiszone einerseits und der Trennzone andererseits auftreten.

Bei einer unter Einhaltung dieser durch die angewandte Technologie festgelegten, auf minimalen Flächenbedarf ausgerichteten Bemessungsregeln aufgebaute I²L-Struktur weisen die sich gegenüberliegenden injizierenden und rückinjizierenden Kanten der den lateralen Transistor bildenden Injektionszone und der Basiszone des invertierenden Transistors die geringstmögliche Länge auf. Diese Kantenlänge ist aber ausschlaggebend für den Wirkungsgrad der Injektion und der Rückinjektion von Minoritätsladungsträgern, mit anderen Worten, diese Kantenlänge bestimmt die Stromverstärkung des lateralen Transistors in Vorwärts- und Rückwärtsrichtung.

In vielen Anwendungsfällen der I²L-Grundschaltung, insbesondere auch bei ihrer Verwendung in nach Art eines Flip-Flops aufgebauten Speicherzellen sind diese Stromverstärkungen unter Ümständen zu gering, um betriebssichere Schaltungen zu erhalten.

Dies äussert sich darin, dass insbesondere beim Abfühlen des Leitzustandes des invertierenden Transistors das bei leitendem Transistor durch Rückinjektion von Ladungsträgern an der Injektionszone gelieferte Signal unter Umständen zu schwach ist, um beispielsweise bei Speicherzellen ein eindeutiges Lesesignal feststellen zu können.

Es ist die der Erfindung zugrunde liegende Aufgabe, eine Halbleiterstruktur für eine I²L-Grundschaltung und eine Verwendung dieser Grundschaltung in Form einer Speicherzelle und Speichermatrix anzugeben, die ausgehend von prozessbedingten Mindestabmessungen der einzelnen Halbleiterzonen, der Kontaktflächen und des Abstandes der erforderlichen, die Struktur umgebenden, injektionshemmenden Trennzone eine gegenüber entsprechenden bekannten I²L-Grundschaltungen erhöhte Stromverstärkung des lateralen Transistors in Vorwärts- und in Rückwärtsrichtung aufweist, ohne dass damit eine ins Gewicht fallende erhöhte parasitäre Kapazität zur Trennzone hin in Kauf genommen werden müsste.

Gemäss der Erfindung wird diese Aufgabe dadurch gelöst, dass die Injektionszone und die Basiszone bei einer auf minimalen Flächenbedarf ausgerichteten Bemessung jeweils im Bereich ihrer beiden sich gegenüberliegenden Kanten bis zu oder in die Trennzone ausgedehnt sind, während sie im Bereich ihrer restlichen Kanten den vorgegebenen Abstand davon aufweisen.

Eine vorteilhafte Anwendung und Ausgestaltungen der Erfindung sind in den Unteransprüchen niedergelegt. Über den ersten Teil des Anspruchs 1 hinaus sind auch die in den kennzeichnenden Teilen der Ansprüche 5 bis 11 enthaltenen Merkmale aus der DE-A-2 612 666 bekannt.

Die Erfindung wird im folgenden anhand der in der Zeichnung dargestellten Ausführungsbeispiele näher erläutert.

Es zeigen:

Fig. 1A die Draufsicht eines Ausschnittes einer integrierten Halbleiteranordnung mit einer erfindungsgemässen I²L-Struktur,

Fig. 1B eine Schnittansicht der I²L-Struktur gemäss Fig. 1A,

Fig. 1C das Ersatzschaltbild der Struktur gemäss den Fign. 1A und 1B, aus der sich die Wirkungsweise der Schaltung ergibt,

Fig. 2A das Ersatzschaltbild einer erfindungsgemässen Speicherzelle, die aus zwei kreuzgekoppelten Grundschaltungen gemäss Fig. 1C zusammengesetzt ist,

Fig. 2B die Draufsicht eines Ausschnittes einer integrierten Speichermatrix mit erfindungsgemässen Speicherzellen und

Fig. 2C Schnittansichten der Speichermatrix gemäss Fign. 2B. und 2D.

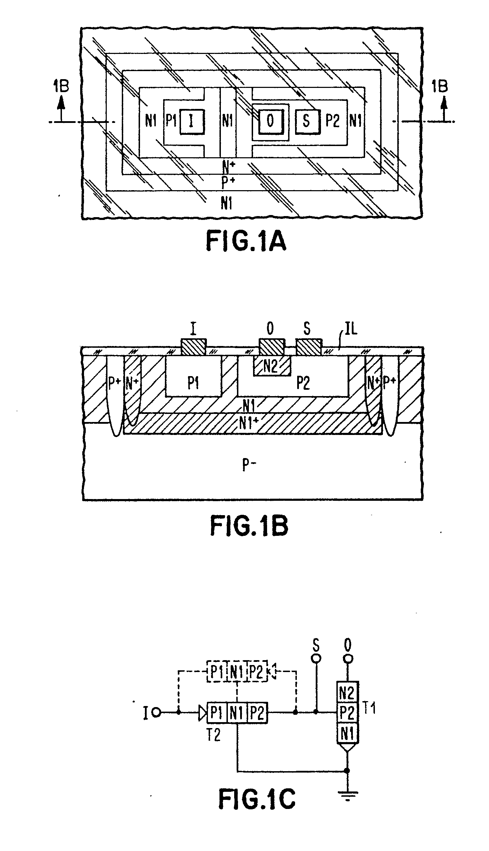

Die in Fig. 1A in Draufsicht und in Fig. 1B in Schnittansicht dargestellte Halbleiterstruktur ist die Grundstruktur der unter dem Begriff «Integrated Injection Logic» bekannten logischen Grundschaltung. Der grundsätzliche Aufbau sowie die Wirkungsweise dieser Struktur sind in der eingangs genannten Literatur ausführlich beschrieben, so dass hier lediglich eine zusammenfassende Darstellung gegeben zu werden braucht. Die Bezeichnungen der einzelnen Schichten und Zonen sind so gewählt, dass aus ihnen gleichzeitig der Leitungstyp zu ersehen ist.

Als Ausgangsmaterial dient ein schwach dotiertes Halbleitersubstrat $P^-$ eines ersten Leitungstyps, also beispielsweise des P-Leitungstyps. Auf dem Halbleitersubstrat befindet sich eine hochdotierte vergrabene Zone $N1^+$ des entgegengesetzten Leitungstyps. Über der vergrabenen Zone $N1^+$ ist eine N-dotierte, epitaktisch aufgebrachte Halbleiterschicht N1 angeordnet. In die Halbleiterschicht N1 sind in einem gewissen Abstand voneinander zwei zur Halbleiterschicht entgegengesetzt dotierte Zonen P1 und P2 eingebracht. In der Zone P2 befindet sich eine weitere, dazu entgegengesetzt dotierte Zone N2. Diese Struktur ist von einer hochdotierten Ringzone $N^+$ des Leitungstyps der Halbleiterschicht N1 umgeben. Diese Ringzone dient als Trennzone, die eine unerwünschte laterale Injektion von Minoritätsladungsträgern verhindert. Diese Trennzone $N^+$ kann, wie im betrachteten Ausführungsbeispiel dargestellt, die gesamte Halbleiterschicht N1 durchdringen und bis in die vergrabene Zone $N1^+$ reichen. Unter Umständen reicht der injektionshemmende Effekt dieser Trennzone aber auch aus, wenn sie nur teilweise die Halbleiterschicht N1 durchdringt. Falls eine elektrische Isolation der Struktur zu benachbarten Strukturen erforderlich ist, so ist die Trennzone N+ von einer hochdotierten Isolationszone P+ des Leitungstyps des Halbleitersubstrats umgeben. Die Isolation wird durch den zwischen der Isolationszone P+ und der Halbleiterschicht N1 gebildeten sperrenden PN-Übergang bewirkt. Vervollständigt ist die Struktur durch eine abdeckende Isolationsschicht IL, die Kontaktfenster zum Einbringen von Kontakten I, O und S zu den entsprechende Zonen P1, N2 und P2 aufweist.

Die bis hierher beschriebene Struktur entspricht der bereits bekannten Struktur. Während bei der bekannten Struktur die Zonen P1 und P2 im wesentlichen eine rechteckförmige Form haben, sind sie, wie aus Fig. 1A zu ersehen, bei der erfindungsgemässen Struktur im Bereich ihrer sich gegenüberliegenden Kanten bis in die Trennzone N+ ausgedehnt, während sie im Bereich ihrer restlichen Kanten wie bei der bekannten Struktur einen gewissen Abstand von dieser Trennzone N+ aufweisen. Das wesentliche, die Erfindung kennzeichnende Merkmal der Ausdehnung der Zonen P1 und P2 im Bereich der sich gegenüberliegenden Kanten bis in die Trennzone N+ braucht bei der Beschreibung der allgemeinen Wirkungsweise der Grundstruktur zunächst nicht beachtet zu werden.

Das elektrische Ersatzschaltbild der bis hierher beschriebenen Struktur ist in Fig. 1C dargestellt, wobei durch die gleichartige Bezeichnung der einzelnen identischen Zonen ein direkter Vergleich zwischen Struktur und Ersatzschaltbild ermöglicht wird.

Demnach besteht die erfindungsgemäss verwendete invertierende logische Grundschaltung im wesentlichen aus einem invertierenden Transistor T1 mit der Zonenfolge N2, P2, N1, der durch direkte Injektion von Minoritätsladungsträgern gespeist wird. Der invertierende Transistor T1 ist als invers betriebener, vertikaler Transistor aufgebaut. Zum Zwecke der Injektion von Minoritätsladungsträgern ist ein dazu komplementärer Transistor T2 der Zonenfolge P1, N1, P2 vorgesehen, der in der betrachteten Struktur lateral ausgebildet ist. Beide Transistoren sind in einer höchste Integration erlaubenden Weise durch Zusammenlegen gemeinsamer, auf gleichem Potential liegender Halbleiterzonen miteinander integriert. Die Halbleiterschicht N1 dient gleichzeitig als Basiszone des lateralen Transistors T2 und als Emitterzone des vertikalen Transistors T1. Die Injektionszone P1 bildet die Emitterzone des lateralen Transistors T2. Die Zone P2 bildet gleichzeitig die Basiszone des vertikalen, invertierenden Transistors T1 und die Kollektorzone des injizierenden lateralen Transistors T2. Die Zone N2 bildet die Kollektorzone des invertierenden Transistors T1. An der die Emitterzone des injizierenden Transistors bildenden Zone P1 befindet sich ein Injektoranschluss I, über den extern ein Strom eingespeist wird. Dieser Strom liefert den Betriebsstrom für den invertierenden Transistor T1. An der die Basiszone dieses Transistors bildenden Zone P2 liegt ein Steueranschluss S, siehe Fign. 1A, B, C über den der Leitzustand des invertierenden Transistors T1 schaltbar ist. An der Zone N2 befindet sich der Kollektoranschluss O, der gleichzeitig den Ausgang der invertierenden Grundschaltung bildet. Der vom Steuersignal am Steueranschluss S bestimmte Leitzustand des invertierenden Transistors T1 lässt sich über einen Injektionsstrompfad, also die Speisestromzuführung eingeschaltete, nicht dargestellte Abfühlschaltung abfühlen. Dabei wird davon Gebrauch gemacht, dass bei leitendem invertierendem Transistor T1 die Basiszone P2 gleichzeitig eine Emitterwirkung aufweist und einen zum normalen Injektionsstrom bzw. Speisestrom entgegengesetzten Strom in die eigentliche Injektionszone P1 des lateralen Transistor T2 rückinjiziert. Der über den Injektionsanschluss I fliessende Strom weist somit bei leitendem invertierendem Transistor T1 einen geringeren Wert auf als bei gesperrtem Transistor (gleiche Basis-Emitter Spannung VBE vorausgesetzt). Dieser unterschiedliche Strom kann mit einer gebräuchlichen Abfühlschaltung abgefühlt werden. Die Tatsache der Rückinjektion bei leitendem Transistor T1 ist im Ersatzschaltbild durch die durch gestrichelte Linien zusätzlich zum normalen Transistor T2 eingezeichnete, parallele Transistorstruktur angedeutet, bei der also Kollektor und Emitter vertauscht sind. Die Abfühlschaltung kann dabei als Einrichtung ausgebildet werden, die entweder die Stromdifferenz oder eine entsprechende Spannungsdifferenz feststellt. Auf diese Weise erhält man also eine Abfühlmöglichkeit für den Leitzustand des invertierenden Transistors T1, ohne dass zusätzliche Leitungen oder Halbleiterzonen in der bereits vorhandenen Grundstruktur erforderlich wären.

Will man nun die bis hierher beschriebene Struktur so auslegen, dass sie nur den mit heutigen Mitteln technologisch erreichbaren minimalen Platzbedarf aufweist, so ist folgender Sachverhalt festzustellen.

Der minimal mögliche Platzbedarf hängt in erster Linie von der angewandten Technologie ab. Insbesondere sind die photolithographischen Maskierungsprozesse und die erforderlichen Toleranzen bei der Ausrichtung aufeinanderfolgender Maskierungen ausschlaggebend. Unter Ausnutzung aller heutzutage bekannten technologischen Möglichkeiten erreicht man laterale Abmessungen für die Zonen P1 und P2, die so gering sind, dass die Injektion bzw. Rückinjektion von Minoritätsladungsträgern über die noch zur Verfügung stehende Länge der sich gegenüberliegenden Kanten dieser beiden Zonen nicht mehr ausreichend ist, um die Funktion der Struktur sicherstellende Injektions- bzw. Rückinjektionsströme zu erhalten. Dabei ist zusätzlich in Betracht zu ziehen, dass die tatsächlich effektive Kantenlänge gegenüber der theoretisch erreichbaren Kantenlänge im Zuge des Herstellungsprozesses durch Abrundungseffekte weiter reduziert wird. Mit anderen Worten, die Stromverstärkung des lateralen Transistors T2 in Vorwärtsrichtung (ausgezogene Transistorstruktur im Ersatzschaltbild gemäss Fig. 1C) und in

Rückwärtsrichtung (gestrichelte Transistorstruktur im Ersatzschaltbild gemäss Fig. 1C) ist unter Umständen nicht mehr ausreichend. Insbesondere ist beim Abfühlen des Leitzustandes des invertierenden Transistors T1 über den Injektoranschluss I festzustellen, dass die Strom- oder Spannungsdifferenz aufgrund des rückinjizierten Stromes zu gering ist, um ein eindeutig definierbares Abfühlsignal zu erhalten.

Erfindungsgemäss wird nun davon Gebrauch gemacht, dass die die Zonen P1 und P2 umgebende Trennzone N+ einen bestimmten Abstand von diesen Zonen aufweisen muss. Dieser Abstand ist erforderlich, um unzulässig hohe parasitäre Kapazitäten zwischen diesen Zonen und der Trennzone zu vermeiden. Das wesentliche, der Erfindung zugrunde liegende Merkmal besteht darin, die Zonen im Bereich ihrer sich gegenüberliegenden, für die effektive Injektion und Rückinjektion zuständigen Kanten bis in die Trennzone N+ auszudehnen, während die restlichen Kantenbereiche den vorgegebenen Abstand von der Trennzone aufweisen.

Gegenüber den bekannten I²L-Strukturen erhält man mit der erfindungsgemässen Struktur trotz auf ein Minimum reduziertem Flächenbedarf eine maximal mögliche Kantenlänge für die injizierenden bzw. rückinjizierenden·Zonen und zwar ohne dass damit eine ins Gewicht fallende Erhöhung der parasitären Kapazitäten verbunden wäre. Damit erhält man für den lateralen Transistor eine optimale Stromverstärkung sowohl in Vorwärts- als auch in Rückwärtsrichtung, was gleichbedeutend ist mit einem erhöhten Ausgangssignal am Anschluss O des invertierenden Transistors T1 und einem erhöhten Abfühl- bzw. Lesesignal am Injektoranschluss I des lateralen Transistors T2.

Eine Variante des in den Fign. 1A bis 1C dargestellten Ausführungsbeispiels kann darin bestehen, dass anstelle der injektionshemmenden Ringzone N+ und der Isolationszone P+ eine dielektrische Isolationszone vorgesehen wird.

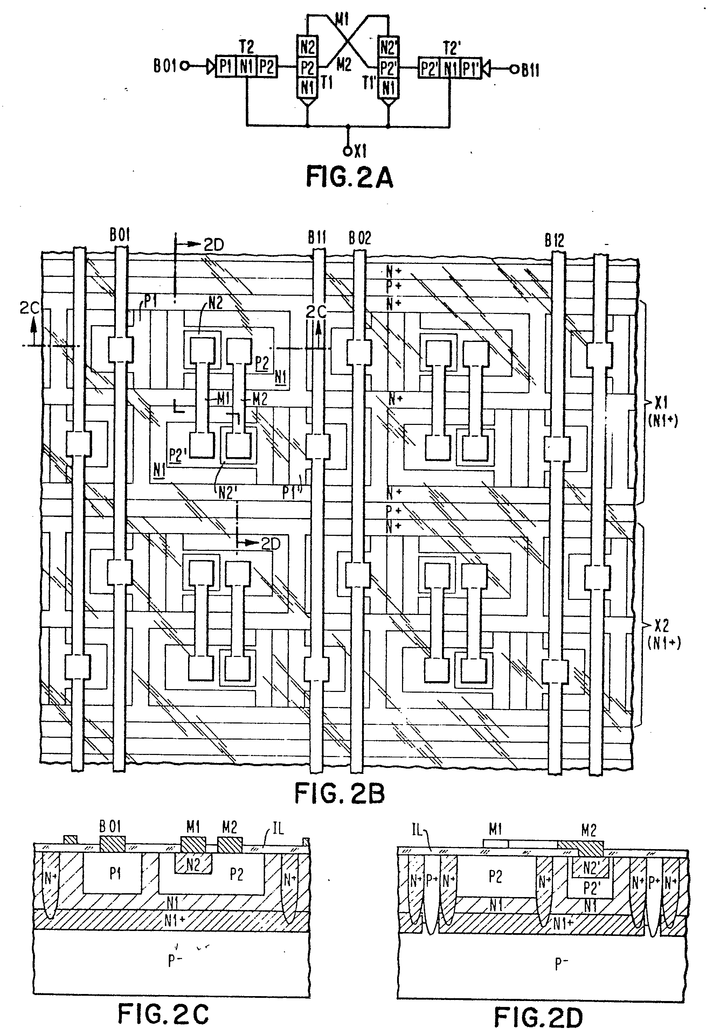

Eine in allen wesentlichen Punkten optimale Anwendung der erfindungsgemässen invertierenden Grundschaltung ergibt sich durch die Vereinigung von zwei Grundschaltungen nach den Fign. 1A bis 1C zu einer hochintegrierten Speicherzelle, wie sie aus dem Ersatzschaltbild nach Fig. 2A zu ersehen ist. Die einzelnen Halbleiterzonen sind wiederum mit den gleichen Bezugszeichen versehen wie in den Fign. 1A bis 1C, wobei die Bezeichnungen der einen der beiden Grundschaltungen zur Unterscheidung mit einem Strichindex versehen wird.

Die Speicherzelle ist nach Art eines Flip-Flops aufgebaut. Die beiden invertierenden Transistoren T1 und T1' bilden die eigentlichen Flip-Flop-Transistoren. Dabei ist jeweils der Kollektor des invertierenden Transistors der einen Grundschaltung mit der Basis des invertierenden Transistors der anderen Grundschaltung verbunden. Auf diese Weise wird die erforderliche gegenseitige Rückkopplung der beiden invertierenden Grundschaltungen erzielt. Die Transistoren T2 und T2' der beiden Grundschaltungen bilden jeweils den injizierenden bzw. rückinjizierenden Transistor für den zugeordneten komplementären invertierenden Transistor T1 und T1'. Der Injektoranschluss I (siehe Fig. 1C) jeder Grundschaltung ist mit einer zugeordneten Bitleitung B01 bzw. B11 eines entsprechenden Bitleitungspaares verbunden. Die Emitter der beiden invertierenden Transistoren T1 und T1' liegen an einer gemeinsamen Adressleitung X.

Der strukturelle Aufbau einer mit derartigen Speicherzellen aufgebauten Speichermatrix ist in Fig. 2B in Draufsicht und in den Fign. 2C und 2D in Teil-Schnittansichten dargestellt.

Die Fig. 2D zeigt einen vier Speicherzellen umfassenden Ausschnitt aus einer Speichermatrix. Die Speicherzellen sind in bekannter Weise in Zeilen und Spalten angeordnet. Die einzelnen Zeilen sind durch in die allen Speicherzellen gemeinsame Halbleiterschicht N1 eingebrachte Isolationszonen P+ gegeneinander elektrisch isoliert. Jeder senkrechten Spalte von Speicherzellen ist ein Bitleitungspaar B01-B11, B02-B12 usw. zugeordnet. Jede Speicherzelle setzt sich aus zwei in der allen Speicherzellen der Matrix gemeinsamen, auf einem Substrat P⁻ angeordneten, epitaktischen Halbleiterschicht N1 eingebrachten Grundstrukturen mit den Zonen P1, P2, N2 und P1', P2', N2' zusammen, welche die anhand der Fign. 1A bis 1C beschriebenen Funktionen haben.

Sämtliche I²L-Grundstrukturen einer Zeile sind gegen die die Zeilen definierenden Isolationszonen P+ und gegen die jeweils benachbarte I²L-Grundstruktur durch eine injektioshemmende Trennzone N+ abgegrenzt. Im betrachteten Ausführungsbeispiel sind die beiden jeweils eine Speicherzelle bildenden Grundstrukturen um 180° gegeneinander gedreht. Man erreicht dadurch, dass die Kollektorzonen N2 und N2' der beiden invertierenden Transistoren T1 und T1' optimal zur aktiven Kante der zugehörigen Basiszone P2 bzw. P2' zu liegen kommen und die Kreuzkoppelung als möglichst kurze, parallele Leiterzüge M1 und M2 ausführbar sind.

Das bei der erfindungsgemässen Speicherzelle wesentliche Merkmal besteht, wie bereits für die einzelnen Grundstrukturen anhand der Fign. 1A bis 1C beschrieben, wiederum darin, dass die Zonen P1 und P2 bzw. P1' und P2' im Bereich ihrer injizierenden bzw. rückinjizierenden Kanten bis in die Trennzone N+ ausgedehnt sind, also ausgehend von minimal gewählten Abmessungen der Gesamtstruktur eine maximal mögliche aktive Kantenlänge aufweisen. Parasitäre Kapazitäten sind weiterhin klein gehalten, da diese Zonen in ihren restlichen Kantenbereichen den erforderlichen Abstand von dieser Trennzone N+ aufweisen.

Die Bitleitungen BOX jedes Paares sind jeweils mit den injizierenden Zonen P1 und die Bitleitungen B1X mit den injizierenden Zonen P1' jeder Speicherzelle der zugeordneten Spalte verbunden. Die Kreuzkopplung zwischen jeweils der Kollektorzone N2, N2' des einen invertierenden Transistors T1, T1' und der Basiszone P2, P2' des anderen invertierenden Transistors besteht aus den bereits genannten, über einer Isolationsschicht IL verlaufenden Leiterzügen M1 und M2. Die Adressleitungen X1, X2 usw. jeder Zeile von Speicherzellen wird von der in jeder Zeile angeordneten hochdotierten vergrabenen Zone N1$^+$ gebildet.

Aus dieser Darstellung ist die optimal integrierte, einfach aufgebaute und einfach herzustellende Struktur der Speicherzelle bzw. der gesamten Speichermatrix zu erkennen.

Zum Betrieb der Speichermatrix ist nur jeweils ein Bitleitungspaar je Spalte und eine Adressleitung X in Form einer vergrabenen Zone N1$^+$ je Zeile erforderlich. Die Betriebsweise einer erfindungsgemässen Speicherzelle sei anhand der Fig. 2A näher betrachtet. Im Ruhezustand sind alle Adressleitungen X auf dem gleichen Potential. Beispielsweise beträgt dieses Potential 0,5 Volt. Die beiden Bitleitungen B01 und B11 weisen ebenfalls gleiches Potential auf, das etwa 0,7 Volt höher ist, als das der Adressleitung X. Das Potential der Bitleitungen wird mit Hilfe eines Reglers so eingestellt, dass in die injizierenden, lateralen Transistoren T2, T2' aller Speicherzellen derselbe Strom fliesst. Dies gilt bei gleich grossen Basis-Emitter-Spannungen. Falls die Stromverstärkung der invertierenden Transistoren T1 von T1', in Emitterschaltung grösser als 1 ist, nimmt das Flip-Flop eine stabile Lage ein. Der Ruhestrom der Zelle kann dabei sehr klein gewählt werden.

Zum Adressieren der Speicherzelle wird das Potential der Adressleitung X um einige 100 Millivolt abgesenkt, beispielsweise auf 0 Volt.

Für den Lesevorgang gibt es zwei verschiedene Operationsmöglichkeiten.

Die eine Leseoperation besteht darin, dass beide Bitleitungen dasselbe Potential eingeprägt bekommen, so dass die beiden injizierenden, lateralen Transistoren T2, T2' den gleichen Strom führen. Vorzugsweise wird dieser Strom gegenüber dem Ruhezustand höher gewählt, um eine grössere Geschwindigkeit zu erzielen. Die an demselben Bitleitungspaar liegenden nicht selektierten Speicherzellen werden dabei praktisch von der Stromversorgung abgeschaltet, da die Emitter-Basis-Spannung der entsprechenden lateralen Transistoren um einige 100 Millivolt niedriger ist als die Emitter-Basis-Spannung der invertierenden Flip-Flop-Transistoren T1, T1' der selektierten Adressleitung X. Die Information der nicht selektierten Speicherzellen bleibt aber durch die gespeicherte Ladung in den Flip-Flop-Transistorkapazitäten für eine verglichen mit der Lesezeit lange Zeit erhalten. Nimmt man einen Speicherzustand der selektierten Zelle an, bei dem der Transistor T1 leitend und der Transistor T1' gesperrt ist, so wird in die Bitleitung B01 aufgrund des Effektes der Rückinjektion ein Strom rückgespeist, nicht dagegen in die Bitleitung B11. In die beiden Bitleitungen fliesst demnach ein unterschiedlicher Strom. Diese Stromdifferenz kann mit Hilfe einer Abfühlschaltung in Form eines niederohmigen Anzeigeverstärkers gemessen werden und liefert eine Aussage über den Speicherzustand der Speicherzelle.

Die zweite Möglichkeit, eine Leseoperation durchzuführen, besteht darin, dass man anstelle eingeprägter Spannungen eingeprägte Ströme auf den Bitleitungen verwendet. An den Bitleitungen ist dann eine Spannungsdifferenz festzustellen, die sich mit Hilfe eines angeschlossenen Differenzverstärkers verstärken lässt und ein den Speicherzustand der Speicherzelle kennzeichnendes Signal liefert.

Eine Schreiboperation ist ausserordentlich einfach durchzuführen. Wie bei einer Leseoperation wird die entsprechende Adressleitung X um einige 100 Millivolt abgesenkt. In einer der beiden Bitleitungen wird ein Strom zugeführt. Soll beispielsweise der Flip-Flop-Transistor T1 in den leitenden Zustand gebracht werden, dann wird nur der Bitleitung B01 ein Strom zugeführt. Ein grosser Teil dieses Stromes fliesst in die Basiszone des Flip-Flop-Transistors T1 und schaltet diesen Transistor ein. Damit ist der Speicherzustand der Speicherzelle festgelegt.

Für die erfindungsgemässe Speicherzelle ergeben sich zusammengefasst folgende Vorteile. Der in Fign. 2B, 2C und 2D dargestellte schematische Strukturaufbau zeigt, dass die Speicherzelle nur eine sehr geringe Halbleiterfläche benötigt. Dies trifft insbesondere auch deshalb zu, da die Struktur gezielt so ausgelegt ist, dass die technologisch kleinstmöglichen lateralen Abmessungen verwirklicht werden. Sämtliche Zellen einer Matrix mit gemeinsamer X-Adresse sind in einem streifenförmigen Isolationsgebiet (Zeile) untergebracht, wobei die niederohmige, vergrabene N1$^+$ gleichzeitig als Emitter für die Flip-Flop-Transistoren, also die beiden invertierenden Transistoren T1, T1' der erfindungsgemässen Grundschaltung, sind in bekannter Weise invers ausgeführt. Lediglich durch das zusätzliche Einbringen zweier extrem kleiner Zonen P1 und P1' lassen sich sämtliche für die Stromversorgung und für die Schreib/Lese-Operationen erforderlichen Funktionen ausführen.

Im Ruhezustand arbeiten die Zonen P1 und P1' als Emitter, die Zonen P2 und P2' als Kollektoren. Beim Schreiben arbeitet die Zone P1 oder P1' als Emitter und die Zone P2 und P2' als Kollektor. Beim Lesen arbeitet die Zone P2 oder die Zone P2' als Emitter und die Zone P1 oder die Zone O1' als Kollektor. Die beiden Zonen P1 und P1' sind an die Bitleitungen B01 und B11 angeschlossen. Nur diese beiden Bitleitungen sind also erforderlich, um die Speicherzelle in einer Speichermatrix zu verdrahten.

Neben der einfachen Betriebsweise sind nur sehr kleine Spannungshübe erforderlich, um die Speicherzelle zu betreiben. Als Folge davon erhält man den Vorteil, dass nur einfache periphere Schaltkreise erforderlich sind und dass bei niedrigen Versorgungsspannungen ein ausserordentlich günstiges Leistungs/Geschwindigkeitsverhältnis erzielt wird. Trotz minimaler lateraler Abmessungen der einzelnen Speicherzellen wird durch die erfindungsgemässe Ausdehnung der beiden Zonen P1 und P2 im Bereich ihrer sich gegenüberliegenden Kanten bis in die Trennzone N$^+$

erreicht, dass ausreichend grosse Lesesignale zur Verfügung stehen.

## Patentansprüche

1. Monolithisch integrierte Halbleiteranordnung mit mindestens einer I²L-Struktur, die eine Injektionszone (P1) und einen invertierenden Transistor (T1) enthält, wobei die Injektionszone (P1) und lateral dazu die Basiszone (P2) des gleichen ersten Leitungstyps in einer die Emitterzone des Transistors (T1) bildenden Halbleiterschicht (N1) des zweiten Leitungstyps angeordnet sind, der Transistor (T1) durch eine in der Basiszone (P2) liegende Kollektorzone (N2) des zweiten Leitungstyps vervollständigt ist und die I²L-Struktur mindestens teilweise von einer in einem vorgegebenen Abstand von der Injektions- und Basiszone in die die Emitterzone des Transistors bildende Halbleiterschicht (N1) eingebrachten Trennzone (N⁺) umgeben ist, dadurch gekennzeichnet, dass die Injektionszone (P1) und die Basiszone (P2) bei einer auf minimalen Flächenbedarf ausgerichteten Bemessung jeweils im Bereich ihrer beiden sich gegenüberliegenden Kanten bis zu oder in die Trennzone (N⁺) ausgedehnt sind, während sie im Bereich ihrer restlichen Kanten den vorgegebenen Abstand davon aufweisen.

2. Halbleiteranordnung nach Anspruch 1, dadurch gekennzeichnet, dass die Trennzone aus einer dielektrischen Ringzone besteht.

3. Halbleiteranordnung nach Anspruch 1, dadurch gekennzeichnet, dass die Trennzone aus einer höher als die Halbleiterschicht (N1) dotierten Ringzone (N⁺) des zweiten Leitungstyps besteht.

4. Halbleiteranordnung nach Anspruch 3, dadurch gekennzeichnet, dass die Ringzone (N⁺) zumindest teilweise von einer Isolationszone (P⁺) des ersten Leitungstyps umgeben ist.

5. Halbleiteranordnung nach einem der Ansprüche 1 bis 4, dadurch gekennzeichnet, dass an die Injektionszone (P1) eine Abfühlschaltung angeschlossen ist, über die der Leitzustand des invertierenden Transistors (T1) aufgrund des im leitenden Zustand von der Basiszone (P2) in die Injektionszone (P1) rückinjizierten Stromes abgefühlt wird.

6. Speicherzelle unter Verwendung der Halbleiteranordnung nach den Ansprüchen 1 bis 5, wobei die Speicherzelle aus zwei nach Art eines Flip-Flops kreuzgekoppelten I²L-Strukturen besteht, dadurch gekennzeichnet, dass die Adressierung der Speicherzelle über die Injektionszonen (P1, P1') und die gemeinsame Emitterzone (N1 bzw. N1⁺) der invertierenden Transistoren (T1, T1') erfolgt, wobei beim Einschreiben durch Injektion von Ladungsträgern über eine der beiden Injektionszonen der zugehörige invertierende Transistor leitend wird und beim Lesen der durch die von der Basiszone des leitenden Transistors in die zugehörige Injektionszone rückinjizierten Ladungsträger hervorgerufene Strom abgefühlt wird.

7. Speicherzelle nach Anspruch 6, dadurch gekennzeichnet, dass an jede Injektionszone (P1, P1') eine der Bitleitungen (B01, B11) eines der Speicherzelle zugeodneten Bitleitungspaares angeschlossen ist, über das der Betriebsstrom und die Schreib/Lese-Signale zugeführt werden.

8. Speicherzelle nach Anspruch 7, dadurch gekennzeichnet, dass zur Selektion einer Speicherzelle eine mit der Emitterzone (N1) der invertierenden Transistoren (T1, T1') verbundene Adressleitung (X) vorgesehen ist.

9. Speicherzelle nach Anspruch 8, dadurch gekennzeichnet, dass als Adressleitung (X) in der gemeinsamen Emitterzone (N1) der invertierenden Transistoren (T1, T1') eine vergrabene, hochdotierte Zone (N1⁺) des gleichen Leitfähigkeitstyps angeordnet ist.

10. Speicherzelle nach den Ansprüchen 6 bis 9, dass zwei der Schaltungen nebeneinander integriert sind und dass die Kreuzkoppelung durch aufgebrachte Leiterzüge (M1, M2) hergestellt ist.

11. Integrierte Speichermatrix unter Verwendung der Speicherzelle nach den Ansprüchen 6 bis 10, dadurch gekennzeichnet, dass die Emitterzonen (N) sämtlicher invertierender Transistoren (T1, T1') eine durchgehende Halbleiterschicht bilden, dass die Zeilen der Matrix durch streifenförmige Trennzonen definiert sind, dass zwischen den I²L-Strukturen in einer Zeile ebenfalls Trennzonen vorgesehen sind und dass für sämtliche Speicherzellen einer Zeile eine gemeinsame, die Adressleitung (X) bildende, vergrabene Zone (N1⁺) vorgesehen ist, während die Bitleitungspaare spaltenweise die Injektionsgebiete (P1, P1') kontaktieren.

12. Integrierte Speichermatrix nach Anspruch 11, dadurch gekennzeichnet, dass die I²L-Strukturen in einer Zeile in wabenartig aufgebauten Trennzonen (N⁺) angeordnet sind.

## Claims

1. Monolithically integrated semiconductor arrangement with at least one I²L structure including an injection zone (P1) and an inverting transistor (T1), wherein said injection zone (P1) and lateral thereto the transistor base zone (P2) of the same first conductivity type are disposed within a semiconductor layer (N1) of the second conductivity type forming the emitter zone of said transistor (T1), said transistor (T1) being completed by a collector zone (N2) of the second conductivity type disposed within said base zone (P2), and said I²L structure being surrounded at least partly by a separating zone (N⁺) introduced at a predetermined spacing from said injection and base zone into said semiconductor layer (N1) forming the emitter zone of said transistor, characterized in that said injection zone (P1) and said base zone (P2), if dimensioned to suit minimal area requirements, extend up to or into said separating zone (N⁺) in the region of their two edges facing each other, whereas in the region of their remaining edges they are spaced from said separating zone by a predetermined distance.

2. Semiconductor arrangement according to claim 1, characterized in that said separating zone consists of a dielectric ring zone.

# 0004871

## 15

3. Semiconductor arrangement according to claim 1, characterized in that said separating zone consists of a ring zone (N+) of said second conductivity type which is doped more heavily than said semiconductor layer (N1).

4. Semiconductor arrangement according to claim 3, characterized in that said ring zone (N+) is surrounded at least partly by an isolation zone (P+) of said first conductivity type.

5. Semiconductor arrangement according to any one of the claims 1 to 4, characterized in that a sense circuit is connected to said injection zone (P1), via which the conductive state of said inverting transistor (T1) is sensed on the basis of the current said base zone (P2) reinjects into said injection zone (P1) in the conductive state.

6. Storage cell utilizing the semiconductor arrangement according to claims 1 to 5, wherein said storage cell consists of two I²L structures cross-coupled in the manner of a flip-flop, characterized in that said storage cell is addressed via the injection zones (P1, P1') and said common emitter zone (N1 and N1+, respectively) of the inverting transistors (T1, T1'), wherein during writing the appertaining inverting transistor becomes conductive by the injection of charge carriers via one of said two injection zones and wherein during reading the current is sensed which is generated by charge carriers reinjected from said base zone of said conductive transistor into the appertaining injection zone.

7. Storage cell according to claim 6, characterized in that each of said injection zones (P1, P1') has connected to it one of the bit lines (B01, B11) of a bit line pair associated with said storage cell, via which the operating current and the read/write signals are applied.

8. Storage cell according to claim 7, characterized in that for selection of a storage cell, an address line (X) is provided which is connected to said emitter zone (N1) of said inverting transistors (T1, T1').

9. Storage cell according to claim 8, characterized in that as an address line (X) a buried, heavily doped zone (N1+) of the same conductivity type is disposed within said common emitter zone (N1) of said inverting transistors (T1, T1').

10. Storage cell according to claims 6 to 9, characterized in that two of said circuits are integrated adjacent to each other and that cross-coupling is obtained by applied conductors (M1, M2).

11. Integrated storage matrix utilizing said storage cell according to claims 6 to 10, characterized in that the emitter zones (N) of all inverting transistors (T1, T1') form a continuous semi-conductor layer, that the lines of said matrix are defined by stripe-shaped separating zones, that separating zones are also provided between the I²L structures in a row, and that all storage cells of a row have a common buried zone (N1+) forming the address line (X), whereas said bit line pairs contact said injection zones (P1, P1') column-by-column.

12. Integrated storage matrix according to

## 16

claim 11, characterized in that said I²L structures in a row are arranged in honeycomb-type separating zones (N+).

## Revendications

1. Dispositif semi-conducteur monolithique intégré avec au moins une structure I²L, comportant une région d'injection (P1) et un transistor inverseur (T1), dans lequel la région d'injection (P1) et, latéralement à celle-ci, la région de base (P2) du même premier type de conductivité sont disposées dans une souche semi-conductrice (N1) du second type de conductivité formant la région d'émetteur du transistor (T1), dans lequel le transistor (T1) est complété par une région de collecteur (N2) du second type de conductivité disposée dans la région de base (P2), et dans lequel la structure I²L est entourée, au moins partiellement, par une région de séparation (N+) diffusée dans la couche semi-conductrice (N1) formant la région d'émetteur du transistor, espacée de la région d'injection et de la région de base d'une distance prédéterminée, caractérisé en ce que la région d'injection (P1) et la région de base (P2), lorsque les dimensions sont déterminées pour une surface minimum, s'étendent jusqu'à, ou pénétrent dans, la région de séparation (N+) aux endroits où leurs bords se font face alors qu'aux endroits des bords restants, elles sont espacées de la distance prédéterminée.

2. Dispositif semi-conducteur selon la revendication 1, caractérisé en ce que la région de séparation est composée d'une région diélectrique annulaire.

3. Dispositif semi-conducteur selon la revendication 1, caractérisé en ce que la région de séparation est composée d'une région annulaire (N+) du second type de conductivité qui est dopée plus fortement que la couche semi-conductrice (N1).

4. Dispositif semi-conducteur selon la revendication 3, caractérisé en ce que la région annulaire (N+) est entourée, au moins partiellement, par une région d'isolation (P+) du premier type de conductivité.

5. Dispositif semi-conducteur selon l'une quelconque des revendications 1 à 4, caractérisé en ce que la région d'injection (P1) est connectée à un circuit de détection qui détecte l'état conducteur du transistor inverseur (T1) grâce au courant réinjecté, à l'état conducteur, dans la région d'injection (P1) par la région de base (P2).

6. Cellule de mémoire utilisant le dispositif semi-conducteur selon l'une quelconque des revendications 1 à 5, qui comporte deux structures I²L en montage croisé, à la façon d'une bascule, caractérisée en ce que l'adressage de la cellule de mémoire se fait à travers les régions d'injection (P1, P1') et la région d'émetteur commune (N1 et N1+, respectivement) du transistor inverseur (T1, T1'), le transistor inverseur correspondant devenant conducteur lors de l'écriture par injection de porteurs de charge à travers une des deux régions d'injection, et le courant provoqué par les porteurs de charge réinjectés dans la région d'injection correspondante par la région de base du transistor conducteur étant détectée lors de la lecture.

7. Cellule de mémoire selon la revendication 6, caractérisée en ce qu'à chaque région d'injection (P1, P1') est connectée l'une des lignes de bit (B01, B11) d'une paire de lignes de bit associée à la cellule de mémoire à travers laquelle on applique le courant de fonctionnement et les signaux d'écriture et de lecture.

8. Cellule de mémoire selon la revendication 7, caractérisée en ce que l'on prévoit une ligne d'adresse (X) connectée à la région d'émetteur (N1) des transistors inverseurs (T1, T1') pour sélectionner une cellule de mémoire.

9. Cellule de mémoire selon la revendication 8, caractérisée en ce qu'une région enterrée fortement dopée (N1$^+$) du même type de conductivité est disposée comme ligne d'adresse (X) dans la région d'émetteur commune des transistors inverseurs (T1, T1').

10. Cellule de mémoire selon l'une quelconque des revendications 6 à 9, caractérisée en ce que deux circuits sont intégrés l'un à côté de l'autre et en ce que le montage croisé est établi par des conducteurs déposés (M1, M2).

11. Matrice de mémoire intégrée utilisant la cellule de mémoire selon les revendications 6 à 10, caractérisée en ce que les régions d'émetteur (N) de tous les transistors inverseurs (T1, T1') forment une couche semi-conductrice continue, en ce que les lignes de la matrice sont définies par des régions de séparation en forme de bande, en ce que l'on prévoit également des régions de séparation entre les structures I$^2$L dans une ligne, et en ce que l'on prévoit pour toutes les cellules de mémoire d'une ligne une région enterrée commune (N1$^+$) formant la ligne d'adresse (X) alors que les paires de lignes de bit établissent colonne par colonne un contact avec les régions d'injection (P1, P1').

12. Matrice de mémoire intégrée selon la revendication 11, caractérisée en ce que les structures I$^2$L dans une ligne sont disposées dans des régions de séparation (N$^+$) du type nid d'abeille.

**FIG.1A**

**FIG.1B**

**FIG.1C**

0004871

FIG.2A

FIG. 2B

FIG.2C

FIG.2D

13